# EUROPÄISCHE PATENTSCHRIFT

(11) **EP 0 863 052 B1**
(45) Veröffentlichungstag und Bekanntmachung des Hinweises auf die Patenterteilung: **25.07.2001**
(21) Anmeldenummer: 98103752.6
(22) Anmeldetag: 04.03.1998
(51) Int. Cl.: B60R 11/02

(54) **Abnehmbares Bedienteil fur ein Autoradio**
Removable control element for a car radio
Elément de commande pour une radio d'automobile

(30) Priorität: 08.03.1997 DE 19709617
(43) Veröffentlichungstag der Anmeldung: 09.09.1998
(73) Patentinhaber: GRUNDIG Aktiengesellschaft, 90471 Nürnberg (DE)
(72) Erfinder: Winkler, Kurt, 90762 Fürth (DE)

(56) Entgegenhaltungen:
- EP-A- 0 566 128
- EP-A- 0 748 726
- DE-U- 9 412 197

## Beschreibung

Die Erfindung betrifft ein abnehmbares Bedienteil für ein Autoradio, mit den Merkmalen des Oberbegriffs nach Anspruch 1.

In Autoradios werden abnehmbare Bedienteile verwendet, die einen Inkrementgeber für die Einstellung verschiedener Parameter, zum Beispiel der Lautstärke, aufweisen. Der Inkrementgeber wird üblicherweise von zwei Schaltern gebildet, die bei der Drehung des Inkrementgebers um 90° versetzte Schaltzustände einnehmen, wodurch sich der Drehwinkel und die Drehrichtung bestimmen lassen. Zusätzlich kann ein Schalter als Bestätigungselement vorhanden sein, der durch Druck auf den Knopf des Inkrementgebers betätigt wird. Zur Überprüfung, ob sich das abnehmbare Bedienteil im Autoradio befindet, ist ein weiterer Kontakt vorgesehen, an den beispielsweise ein Widerstand angeschlossen ist. Alle Schalter bzw. der Widerstand sind über einen Massekontakt angeschlossen.

Somit weist das abnehmbare Bedienteil zwei Kontakte für den Inkrementgeber, einen Kontakt für das Bestätigungselement, einen Kontakt für den Widerstand und einen Massekontakt, insgesamt also fünf Kontakte auf. Ein derartiges abnehmbares Bedienteil wird beispielsweise bei dem von der Anmelderin hergestellten und unter der Bezeichnung EC 4000 RDS vertriebenen Autoradio eingesetzt.

Wegen der großen Anzahl der Kontakte tritt das Problem auf, daß das abnehmbare Bedienteil nicht ohne weiteres in das zugehörige Autoradio eingesetzt werden kann, weil dies nur in einer bestimmten Stellung möglich ist.

In der gleichzeitig mit dieser Anmeldung eingereichten Anmeldung mit dem Titel "Abnehmbares Bedienteil mit einem Inkrementgeber" ist ein abnehmbares Bedienteil beschrieben, bei dem die gleiche Funktionalität wie beim Stand der Technik mit nur zwei Kontakten, bzw. elektrischen Verbindungen, erreicht werden kann.

Aufgabe der vorliegenden Erfindung ist es deshalb, ausgehend vom bekannten Stand der Technik und der oben erwähnten, gleichzeitig eingereichten Anmeldung, ein abnehmbares Bedienteil anzugeben, bei dem das Einsetzen in das zugehörige Autoradio vereinfacht ist.

Diese Aufgabe wird durch die Merkmale des Anspruchs 1 gelöst.

Der Vorteil des erfindungsgemäßen abnehmbaren Bedienteils ist, daß es in nahezu beliebiger Stellung in das zugehörige Autoradio eingesetzt werden kann, wobei die richtige elektrische Kontaktierung gewährleistet ist.

Weitere Vorteile der Erfindung ergeben sich aus den abhängigen Ansprüchen und der nachfolgenden Beschreibung anhand einer Figur.

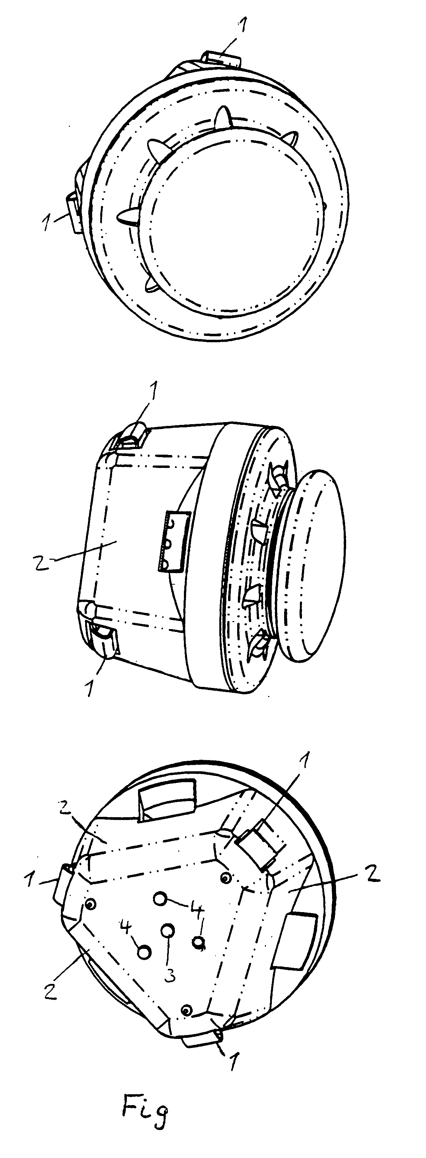

Die einzige Figur zeigt ein erfindungsgemäßes abnehmbares Bedienteil in mehreren Ansichten.

Die Figur zeigt das abnehmbare Bedienteil, welches Halteeinrichtungen 1, beispielsweise Federn, drei Außenflächen 2, einen Kontakt 3 und drei Kontakte 4 aufweist, wobei die Kontakte 4 elektrisch verbunden sind.

Die den hinteren Teil des abnehmbaren Bedienteil bildenden Außenflächen 2 bilden im wesentlichen einen Pyramidenstumpf, auf dessen oberer Fläche die Kontakte 3 und 4 angeordnet sind. Die Kontakte 3 und 4 werden beispielsweise als federnd gelagerte Stifte ausgebildet.

Im vorliegenden Beispiel sind die Kanten des Pyramidenstumpfes gebrochen und die Halteeinrichtungen 1 sind in den sich ergebenden Flanken untergebracht.

Jeder der Außenflächen 2 ist einer der Kontakte 4 zugeordnet, wobei die Position der Kontakte 4 jeweils durch ein Lot auf die Mitte der Strecke der Kontur zwischen den Außenflächen 2 und der oberen Fläche des Pyramidenstumpfes festgelegt ist. Der Kontakt 3 ist im Mittelpunkt der oberen Fläche des Pyramidenstumpfes angebracht.

Im zum abnehmbaren Bedienteil gehörigen Autoradio ist eine Aufnahme für das abnehmbare Bedienteil vorgesehen, die der Pyramidenstumpfform des abnehmbaren Bedienteils angepaßt ist, wodurch das abnehmbare Bedienteil im eingesetzten Zustand im wesentlichen formschlüssig im Autoradio eingesetzt ist. Ebenso finden sich Kontaktstellen in der Aufnahme des Autoradios, die entsprechend den Kontakten 3 und 4 angeordnet sind. Für die Halteeinrichtungen 1 sind in der Aufnahme des Autoradios entsprechende Gegenstücke vorhanden, beispielsweise Vertiefungen für die Federn des abnehmbaren Bedienteils.

Durch die Form des hinteren Teils des abnehmbaren Bedienteils, ist gewährleistet, daß beim Einsetzen des abnehmbaren Bedienteils in die Aufnahme des Autoradios eine Führung derart erfolgt, daß das abnehmbare Bedienteil in jeder beliebigen Stellung eingesetzt werden kann.

Neben den in der Figur dargestellten drei Kontakten 4 sind auch zwei Kontakte 4 mit entsprechenden Kontaktstellen in der Aufnahme des Autoradios ausreichend, da beim dargestellten Pyramidenstumpf mit drei Außenflächen 2 dann immer mindestens eine elektrische Verbindung zwischen Kontakten 4 und den Kontaktstellen in der Aufnahme des Autoradios ergibt.

Neben dem dargestellten abnehmbaren Bedienteil mit drei Außenflächen 2 sind abnehmbare Bedienteile mit einer größeren Anzahl von Außenflächen möglich.

Außerdem wird das Einsetzen des abnehmbaren Bedienteils in das zugehörige Autoradio erleichtert, wenn Kanten und Konturen des pyramidenförmigen Teils des abnehmbaren Bedienteils gebrochen oder abgerundet sind.

## Patentansprüche

1. Abnehmbares Bedienteil für ein Autoradio mit einer Aufnahme für das abnehmbare Bedienteil,
**dadurch gekennzeichnet,**
daß das abnehmbare Bedienteil einen im wesentlichen pyramidenstumpfförmigen Abschnitt aufweist, der mindestens drei Außenenflächen (2) aufweist;
daß die Aufnahme des abnehmbaren Bedienteils des Autoradios entsprechend des pyramidenstumpfförmigen Abschnitts des abnehmbaren Bedienteils ausgeformt ist, und
daß bei in das Autoradio eingesetztem abnehmbaren Bedienteil das abnehmbare Bedienteil im wesentlichen formschlüssig in der Aufnahme des Autoradios in eine Endstellung kommt.

2. Abnehmbares Bedienteil nach Anspruch 1,
**dadurch gekennzeichnet,**
daß das abnehmbare Bedienteil einen Kontakt (3) aufweist, der im Mittelpunkt der von den Außenflächen (2) begrenzten Fläche angeordnet ist,
daß weitere, untereinander elektrisch verbundene, Kontakte (4) vorgesehen sind, deren Position jeweils durch ein Lot auf die Mitte der Strecke der Kontur zwischen den Außenflächen 2 und der von den Außenflächen (2) begrenzten Fläche festgelegt ist, und
daß in der Aufnahme des Autoradios Kontaktstellen an entsprechenden Stellen angeordnet sind.

3. Abnehmbares Bedienteil nach Anspruch 1 oder 2,
**dadurch gekennzeichnet,**
daß die Kanten des pyramidenstumpfförmigen Abschnitts gebrochen sind, und
daß in den sich ergebenden Flanken Halteeinrichtungen (1) angeordnet sind, für die entsprechende Gegenstücke in der Aufnahme des Autoradios vorhanden sind, wobei die Halteeinrichtungen (1) in den Gegenstücken einrasten, wenn sich das abnehmbare Bedienteil in der Aufnahme des Autoradios in seiner Endstellung befindet.

## Revendications

1. Unité de commande amovible pour un autoradio comportant un logement pour l'unité de commande amovible, caractérisée en ce
que l'unité de commande amovible possède une section essentiellement en forme de tronc de pyramide, qui comporte au moins trois surfaces extérieures (2),
que le logement de l'unité de commande amovible de l'autoradio est agencé conformément à la partie en forme de tronc de pyramide de l'unité de commande amovible, et
que lorsque l'unité de commande amovible est insérée dans l'autoradio, l'unité de commande amovible se place essentiellement selon une liaison par formes complémentaires dans le logement de l'autoradio, dans une position finale.

2. Unité de commande amovible selon la revendication 1, caractérisée en ce
que la partie de commande amovible possède un contact (3), qui est disposée au centre de la surface limitée par les faces extérieures (2),
que d'autres contacts (4) reliés électriquement entre eux sont prévus, contacts dont la position est fixée respectivement par une verticale au milieu de la section du contour entre les surfaces extérieures (2) et la surface délimitée par les faces extérieures (2), et
que des points de contact sont disposés en des emplacements correspondants dans le logement de l'autoradio.

3. Unité de commande amovible selon la revendication 1 ou 2, caractérisée en ce que les arêtes de la partie en forme de tronc de pyramide sont biseautées et que dans les flancs obtenus sont disposés des dispositifs de retenue (1), pour lesquels sont prévus des éléments antagonistes correspondants dans le logement de l'autoradio, les dispositifs de retenue (1) s'encliquetant dans les éléments antagonistes lorsque l'unité de commande amovible est située dans le logement de l'autoradio, dans sa position finale.

## Claims

1. Removable operating part for a car radio having a receptacle for the removable operating part, **characterized**
in that the removable operating part has a substantially truncated pyramidal section that has at least three external surfaces (2),
in that the receptacle for the removable operating part of the car radio is shaped so as to match the truncated pyramidal section of the removable operating part, and
in that, when the removable operating part is inserted into the car radio, the removable operating part reaches a final position in a substantially shape-locked manner in the receptacle of the car radio.

2. Removable operating part according to Claim 1, **characterized**
in that the removable operating part has a contact (3) that is disposed in the centre of the surface bounded by the external surfaces (2),
in that further, electrically interconnected contacts (4) are provided whose position is determined in each case by a normal to the centre of the section of the contour between the external surfaces (2) and the surface bounded by the external surfaces (2),
in that contact points are disposed at appropriate points in the receptacle of the car radio.

3. Removable operating part according to Claim 1 or 2, **characterized**
in that the edges of the truncated pyramidal section are chamfered, and
in that there are disposed in the resultant flanks mounting devices (1) for which matching counterpieces are present in the receptacle of the car radio, the mounting devices (1) latching into the counterpieces when the removable operating part is located in its final position in the receptacle of the car radio.
